# DEMANDE DE BREVET EUROPEEN

(11) **EP 4 170 655 A1**
(43) Date de publication de la demande: **26.04.2023**
(21) Numéro de dépôt: 22198595.5
(22) Date de dépôt: 29.09.2022
(51) Int. Cl.: G11C 5/14, G11C 7/20, G11C 7/24, G11C 11/419

(54) **SRAM A INITIALISATION RECONFIGURABLE**

(30) Priorité: 25.10.2021 FR 2111286
(71) Demandeur: Commissariat à l'énergie atomique et aux énergies alternatives, 75015 Paris (FR)
(72) Inventeur: NOEL, Jean-Philippe, 38054 GRENOBLE CEDEX 09 (FR); GIRAUD, Bastien, 38054 GRENOBLE CEDEX 09 (FR); CIAMPOLINI, Lorenzo, 38054 GRENOBLE CEDEX 09 (FR)
(74) Mandataire: Brevalex

(57) **Abrégé**

Dispositif de mémoire statique à accès aléatoire comprenant une matrice mémoire (M₁) dotée d'au moins un ensemble de cellules mémoires SRAM et d'un circuit d'initialisation (100) de cellules dudit ensemble, le circuit d'initialisation étant configuré pour pouvoir effectuer différents types d'initialisation et en particulier une initialisation « déterministe » dans laquelle les cellules s'établissent à une valeur imposée et pour effectuer une initialisation « libre » dans laquelle les cellules s'établissent à une valeur qui dépend de leur procédé de fabrication.

## Description

### DOMAINE TECHNIQUE

La présente invention se rapporte au domaine des mémoires, et en particulier de type SRAM (SRAM pour « Static Random Access Memory » ou mémoire vive statique à accès aléatoire), et concerne plus précisément celui de l'initialisation des mémoires SRAM, notamment lorsque cette initialisation sert de contre-mesure pour empêcher un accès frauduleux.

La présente invention met en œuvre un circuit d'initialisation amélioré permettant d'effectuer différents types d'initialisation.

### ART ANTÉRIEUR

Une mémoire SRAM a pour fonction le stockage d'informations volatiles dont certaines, par exemple telles que des clefs de chiffrement, peuvent être confidentielles et/ou avoir besoin d'être sécurisées. Il existe un nombre réduit de techniques d'initialisation d'une mémoire SRAM.

La technique la plus connue d'initialisation est une initialisation dite « libre », qui consiste dans l'allumage sans contraintes d'un plan de cellules de mémoire. Avec une initialisation libre, l'état dans lequel chaque cellule est initialisée est établi librement. En particulier, lors d'un allumage sans contraintes d'une *k*-éme puce parmi un très grand nombre *Nₚ* ^{~} 10 000 de puces produites, la cellule de l'*i*-ème colonne et de la *j*-éme ligne a une probabilité *pᵢⱼₖ* de s'initialiser à un niveau logique '1' et une probabilité *1-pᵢⱼₖ* de s'initialiser à un niveau logique '0'. Sur un grand nombre ^{~} 100 d'initialisations sans contrainte, la moyenne des valeurs d'initialisation de la cellule de l'*i*-éme colonne et de la *j*-éme ligne dans un plan mémoire de la *k*-éme puce tendra vers cette valeur de probabilité *pᵢⱼₖ*. Il se trouve que cette valeur de probabilité change d'une cellule à l'autre et entre une puce et l'autre, d'une manière que sur un ensemble des cellules de puces différentes on aura une statistique de *p* qui dépend notamment de la variabilité locale de son procédé de fabrication et plus globalement de conditions PVT (« Process », « Voltage », « Temperature », i.e. procédé, tension, température) autrement dit des variations locales et globales du procédé de fabrication, de la vitesse de balayage *V_{SR}* (« slew-rate » selon la terminologie anglo-saxonne exprimé en Volt/seconds) du niveau de tension d'alimentation utilisés, et de la température de fonctionnement.

Avec une telle technique d'initialisation, l'état d'initialisation de la mémoire ou de certaines cellules de la mémoire est ainsi susceptible de constituer une empreinte ou signature numérique. Pour un *k* fixé, ce sont en particulier les cellules avec une forte probabilité de commuter et de s'initialiser à un niveau logique donné (*pᵢⱼₖ* égal ou très proche de 1 pour les cellules a forte tendance de s'initialiser a '1' ; et *pᵢⱼₖ* égal ou très proche de 0 pour les cellules a forte tendance de s'initialiser a '0') qui pourront être utilisées pour former cette empreinte numérique de la k-ème puce.

L'initialisation d'une mémoire qui est en fonctionnement requiert par contre une étape préliminaire d'effacement. Elle peut consister à, dans un premier temps, couper l'alimentation de la mémoire en particulier soit en l'amenant à la masse soit en la plaçant à une tension négative jusqu'à ce que son contenu soit entièrement effacé, puis, à alimenter à nouveau la mémoire.

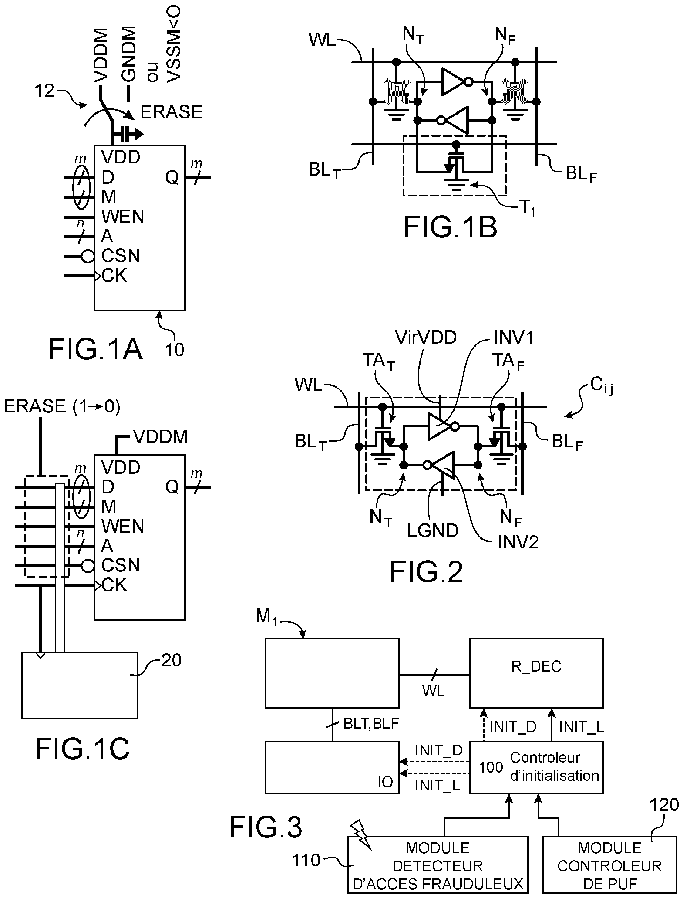

La figure 1A illustre ainsi une technique d'effacement susceptible d'être mise en œuvre pour effectuer une initialisation libre. Un circuit mémoire 10 formé de cellules SRAM et qui est alimenté par une tension d'alimentation VDD est mis à un potentiel de référence GND, par commutation d'un élément interrupteur 12.

Un inconvénient de l'initialisation libre est, qu'en cas d'intrusion malveillante après une telle initialisation, un dispositif tiers peut éventuellement récupérer cette empreinte ou signature numérique.

Une autre technique d'effacement susceptible d'être utilisée pour initialiser une mémoire est illustrée sur la figure 1B et consiste à connecter les nœuds internes NT, NF d'une cellule SRAM après l'avoir préalablement déconnectée de sa source d'alimentation. Cette technique requiert ici l'ajout d'un transistor T₁ au niveau de la cellule mémoire qui permet alternativement de connecter entre eux ou déconnecter l'un de l'autre les nœuds internes NT, NF en fonction de l'état d'un signal de réinitialisation R̅E̅S̅E̅T̅**.** La mise en œuvre de ce type d'effacement nécessite une modification de la structure des cellules qui plus est au détriment de la densité d'intégration.

Une technique d'initialisation dite « déterministe » consiste à venir écrire, adresse après adresse, un contenu prédéterminé et qui peut avoir été préalablement fixé par l'utilisateur ou le concepteur de la mémoire. Dans l'exemple de réalisation illustré sur la figure 1C, un circuit de pilotage 20 d'opérations écriture peut être configuré pour effectuer une initialisation déterministe, dans laquelle on force l'état de chaque cellule mémoire à une valeur déterminée, par exemple en n'écrivant que des valeurs '0' ou que des valeurs '1' dans chaque cellule mémoire. La mise en œuvre de ce type d'initialisation se fait ici au détriment du temps passé à réécrire un certain nombre de points mémoire à différentes adresses, au détriment de la consommation associée ainsi qu'au risque d'une fuite d'information liée à cette réécriture ou réalisée d'une façon malveillante pendant cette longue opération.

On peut utiliser une notation unique pour les deux types d'initialisation, si l'on considère que chaque cellule s'initialise pendant l'allumage, donc pendant une rampe de montée de la tension d'alimentation VDD. La valeur *pᵢⱼₖ* ne dépend pas donc de la valeur finale de la tension d'alimentation, mais plutôt de la vitesse de cette montée en tension, qui peut être indiquée à travers la vitesse de balayage *V_{SR}* (*slew-rate,* exprimé en Volt/seconde). Finalement, la statistique dépend, si les transistors d'accès des lignes sont passants, aussi de la différence de potentiel *ΔV=V(BLTi)-V(BLFi)* qui est imposée par l'extérieur. On peut donc indiquer d'une manière générale une loi de distribution des valeurs d'initialisation des cellules comme *p(P, V_{SR}, ΔV, T)* ; en continuant à indiquer avec *pᵢⱼₖ* la probabilité d'initialisation de la cellule de l'*i*-éme colonne et de la *j*-éme ligne de la *k*-éme puce produite.

La présente demande vise à trouver un nouveau type de circuit d'initialisation des données contenues dans une SRAM qui soit amélioré vis-à-vis d'inconvénients mentionnés ci-dessus.

### EXPOSE DE L'INVENTION

Selon un aspect, la présente invention concerne un dispositif de mémoire statique à accès aléatoire comprenant une matrice mémoire dotée d'au moins un ensemble de cellules mémoires SRAM chacune desdites cellules dudit ensemble comprenant :
- un premier nœud de stockage et un deuxième nœud de stockage,
- un premier inverseur et un deuxième inverseur connectés de façon croisée entre ledit premier nœud et ledit deuxième nœud, le premier inverseur et/ou le deuxième inverseur étant connectés à une ligne d'alimentation dite « haute » pouvant être mise à un potentiel d'alimentation et à une ligne d'alimentation dite « basse » pouvant être mise à un potentiel de référence,
- un premier transistors d'accès au premier nœud de stockage et un deuxième transistor d'accès au deuxième nœud de stockage, le premier transistor d'accès et le deuxième transistor d'accès étant respectivement connectés à une première ligne de bit et à une deuxième ligne, la première ligne de bit et la deuxième ligne de bit étant partagée par lesdites cellules de ladite colonne, une activation ou une désactivation des transistors d'accès étant commandée par une ligne de mot,
le dispositif étant doté en outre d'un circuit d'initialisation de cellules dudit ensemble configuré pour, selon un premier mode d'initialisation,
- selon une première phase dite d'effacement : placer le premier nœud et le second nœud d'au moins un groupe de cellules mémoires à des potentiels égaux l'un de l'autre ou sensiblement égaux l'un de l'autre, puis,
- selon une deuxième phase, polariser la première ligne de bit différemment de la deuxième ligne de bit tout en activant le premier transistor d'accès et le deuxième transistor d'accès des cellules dudit groupe,
le circuit d'initialisation étant configuré en outre pour, selon un deuxième mode d'initialisation,
- selon une première phase dite d'effacement, placer le premier nœud et le second nœud d'au moins un groupe de cellules à des potentiels égaux puis après la première phase :
- selon une deuxième phase, désactiver le premier transistor d'accès et le deuxième transistor d'accès des cellules dudit groupe tout en mettant la ligne d'alimentation haute au potentiel d'alimentation afin d'alimenter le premier inverseur et le deuxième inverseur.

Ainsi le circuit d'initialisation permet, lors de la phase de pré-initialisation de réaliser un effacement de données mémorisées dans la SRAM en égalisant les nœuds internes des cellules mémoires puis de pouvoir initialiser son contenu soit selon un premier mode d'initialisation ou soit selon un deuxième mode d'initialisation.

Le premier mode d'initialisation peut être un mode d'initialisation dit « déterministe » dans lequel on impose une valeur logique à chacune des cellules.

Le deuxième mode d'initialisation peut être un mode d'initialisation dit « libre » dans lequel on laisse basculer librement chaque cellule vers un valeur logique avec une probabilité *pᵢⱼₖ* qui suit une statistique *p(P, V_{SR,} 0, T)* fonction des variations locales et des conditions d'opérations propres de cette cellule et de la puce à qui elle appartient. Un circuit d'initialisation tel que mis en œuvre suivant l'invention donne ainsi la possibilité de combiner au moins deux techniques d'initialisation dans un même circuit mémoire.

Pour permettre de rendre inaccessible le contenu « aléatoire » de la mémoire le premier mode d'initialisation, peut être un mode d'initialisation dit « déterministe » utilisé par exemple lorsqu'un accès frauduleux à la mémoire est détecté.

Pour permettre d'utiliser le contenu de la mémoire comme signature numérique ou empreinte numérique afin par exemple de générer une clef de chiffrement ou bien lorsqu'on souhaite générer un nombre aléatoire, le premier mode d'initialisation peut être utilisé.

Selon un mode de réalisation avantageux, lors de la phase d'effacement, le premier nœud et le second nœud sont placés à des potentiels égaux ou sensiblement égaux l'un de l'autre, en connectant entre elles ladite première ligne de bit et ladite deuxième ligne de bit, le circuit d'initialisation étant doté en outre : d'un élément interrupteur, en particulier un transistor, configuré pour alternativement connecter entre elles et déconnecter l'une de l'autre la première ligne de bit et la deuxième ligne de bit, ledit élément interrupteur étant commandé par un premier signal de commande, de sorte à déconnecter l'une de l'autre la première ligne de bit et la deuxième ligne de bit lors de ladite deuxième phase du premier mode d'initialisation et du deuxième mode d'initialisation.

Avantageusement, le circuit d'initialisation est doté en outre d'un autre élément interrupteur, en particulier un autre transistor, configuré pour alternativement découpler la ligne d'alimentation dite « haute » à une alimentation lors de la phase d'initialisation et pour coupler la ligne d'alimentation « haute » et ladite alimentation lors de la deuxième phase, l'autre élément interrupteur étant commandé par ledit premier signal de commande.

Selon une possibilité de mise en œuvre, la matrice est agencée en outre en rangées d'une ou plusieurs cellules SRAM et dans lequel une pluralité de ligne de mot sont connectées respectivement à ladite pluralité de cellules mémoires SRAM de ladite colonne, chaque ligne mot permettant, lorsqu'elle est activée, de sélectionner la ou les cellules mémoires d'une rangée donnée de cellules SRAM parmi lesdites rangées de cellules SRAM, le circuit d'initialisation comprenant en outre un étage d'activation simultanée desdites lignes de mots pour, lors de la deuxième phase dudit premier mode d'initialisation, effectuer, par le biais d'un deuxième signal de commande, maintenir une activation simultanée desdites lignes de mots dudit groupe de cellules.

Le circuit d'initialisation peut comprendre en outre :
- une première ligne de polarisation apte, lorsqu'elle est couplée à la première ligne de bit à imposer un premier potentiel de polarisation ou un premier courant de polarisation à la première ligne de bit,
- un premier transistor de couplage entre la première ligne de polarisation et la première ligne de bit commandé par un premier signal de contrôle,
- une deuxième ligne de polarisation apte, lorsqu'elle est couplée à la deuxième ligne de bit à imposer un deuxième potentiel de polarisation ou un deuxième courant de polarisation à la deuxième ligne de bit,
- un deuxième transistor de couplage agencé entre la deuxième ligne de polarisation et la deuxième ligne de bit et commandé par un deuxième signal de contrôle.

Avantageusement, le premier transistor de couplage est prévu pour alternativement coupler la première ligne de polarisation à la première ligne de bit ou découpler la première ligne de polarisation de la première ligne de bit, le deuxième transistor de couplage étant prévu pour alternativement coupler la deuxième ligne de polarisation à la deuxième ligne de bit ou découpler la deuxième ligne de polarisation de la deuxième ligne de bit, de sorte que :
lors de la phase d'effacement du premier mode d'initialisation et du deuxième mode d'initialisation : la première ligne de polarisation et la deuxième de polarisation sont découplées respectivement de la première ligne de bit et de la deuxième ligne de bit,
lors de la deuxième phase du premier mode d'initialisation : la première ligne de polarisation est couplée à la première ligne de bit tandis que la deuxième ligne de polarisation est découplée de la deuxième ligne de bit ou bien la première ligne de polarisation est découplée de la première ligne de bit tandis que la deuxième ligne de polarisation est couplée à la deuxième ligne de bit,
lors de la deuxième phase du deuxième mode d'initialisation, la première ligne de polarisation est découplée de la première ligne de bit tandis que la deuxième ligne de polarisation est découplée de la deuxième ligne de bit.

Selon une possibilité de mise en œuvre, lors de la deuxième phase du premier mode d'initialisation l'une desdits première ligne de bit et deuxième ligne de bit est mise au potentiel d'alimentation tandis que l'autre desdits première ligne de bit et deuxième ligne de bit est laissée flottante ou mise à la masse ou à un potentiel inférieur au potentiel de référence servant de masse.

Avantageusement, la première ligne de polarisation et la deuxième ligne de polarisation, sont mises au potentiel d'alimentation.

Selon une possibilité de mise en œuvre, le premier transistor de couplage a une taille W1/L1 et le deuxième transistor de couplage a une taille W2/L2 différente de celle du premier transistor de couplage et/ou au moins l'un desdits premier potentiel de polarisation et deuxième potentiel de polarisation est prévu à une valeur ΔV telle que : GND < ΔV < VDD et en particulier telle que GND < ΔV < VDD/10.

Selon une possibilité de mise en œuvre, le circuit d'initialisation est doté d'un bloc de commande logique apte à recevoir un premier signal de déclenchement du premier mode d'initialisation et un signal de déclenchement du deuxième mode d'initialisation et à produire consécutivement à la réception du premier signal de déclenchement une première séquence de signaux de commande, mettant le circuit d'initialisation dans le premier mode d'initialisation et à produire consécutivement à la réception du deuxième signal de déclenchement, une deuxième séquence desdits signaux de commande, distincte de la première séquence et mettant le circuit d'initialisation dans le deuxième mode d'initialisation.

Selon une mise en œuvre possible parmi lesdits signaux de commande figure :
- un premier signal de commande pour, lorsque le premier signal de commande est dans un premier état, commander une connexion des lignes de bits entre elles et une déconnexion entre la ligne d'alimentation haute et ladite alimentation et lorsque le premier signal de commande est dans un deuxième état commander une déconnexion des lignes de bits l'une de l'autre et une connexion de la ligne d'alimentation haute à ladite alimentation et,
- un deuxième signal de commande pour, lorsque le deuxième signal de commande est dans un premier état, commander une activation simultanée des lignes de mots, lorsque le deuxième signal de commande est dans un deuxième état, commander une désactivation simultanée des lignes de mots.

Avantageusement, le bloc de commande logique peut être doté d'un premier multiplexeur et d'un deuxième multiplexeur, produisant respectivement le premier signal de commande et le deuxième signal de commande, une première entrée du premier multiplexeur étant reliée à une deuxième entrée du deuxième multiplexeur et recevant un signal d'effacement dont l'état dépend du premier signal de déclenchement et du deuxième signal de déclenchement, une deuxième entrée du premier multiplexeur étant reliée à une première entrée du deuxième multiplexeur, et recevant le signal d'effacement avec un retard prédéterminé, le deuxième signal de déclenchement formant un signal de sélection commun au premier multiplexeur et au deuxième multiplexeur.

Avantageusement, un changement d'état du deuxième signal de déclenchement est consécutif à une détection d'accès frauduleux au dispositif mémoire.

Selon une possibilité de mise en œuvre, un changement d'état du premier signal de déclenchement est consécutif à une émission d'un signal provenant d'un module configuré pour générer une signature numérique et/ou une clef d'encryptage et/ou un nombre aléatoire.

Avantageusement, lors de la première phase du premier mode d'initialisation et du deuxième mode d'initialisation, la ligne d'alimentation « haute » est découplée d'une alimentation au potentiel d'alimentation VDD, de sorte à ne pas alimenter le premier inverseur et le deuxième inverseur,
et dans lequel lors de la deuxième phase du premier mode et du deuxième mode d'initialisation, la ligne d'alimentation « haute » est couplée à une alimentation au potentiel d'alimentation VDD, de sorte à alimenter le premier inverseur et le deuxième inverseur.

La présente invention concerne également l'utilisation d'un dispositif tel que défini plus haut pour générer une signature numérique et/ou une clef d'encryptage et/ou un nombre aléatoire.

La présente invention concerne également un procédé de commande d'un dispositif tel que défini précédemment, dans lequel :
lors d'une première étape d'initialisation selon le premier mode d'initialisation, au moins une ligne de polarisation donnée parmi lesdites lignes de polarisation est mise à un potentiel de polarisation donné ΔV1 compris entre le potentiel de référence et le potentiel d'alimentation VDD et en particulier tel que ΔV1 < VDD/10, puis
lors d'une deuxième étape d'initialisation selon le premier mode d'initialisation, ladite ligne de polarisation donnée est mise à un potentiel de polarisation ΔV2 différent du potentiel de polarisation donné et compris entre le potentiel de référence et le potentiel d'alimentation VDD et en particulier tel que ΔV2 < VDD/10.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels°:
Les figures 1A, 1B et 1C servent à illustrer différentes techniques d'effacement connues d'une mémoire SRAM.
La figure 2 sert à illustrer une cellule mémoire SRAM susceptible d'être intégrée dans un dispositif mémoire suivant l'invention.
La figure 3 sert à illustrer un circuit d'initialisation de mémoire SRAM tel que mis en œuvre suivant un mode de réalisation de la présente invention et qui est configuré pour réaliser une initialisation de cellules mémoires selon au moins deux types d'initialisation différents et en particulier une initialisation déterministe et une initialisation libre.
La figure 4 sert à illustrer un circuit d'initialisation de mémoire SRAM tel que mis en œuvre suivant un mode de réalisation particulier de la présente invention et dans lequel l'initialisation de cellules peut être réalisée selon un mode d'initialisation déterministe et selon un mode d'initialisation libre.
Les figures 5A et 5B servent à illustrer respectivement, par le biais de chronogrammes, une phase d'initialisation déterministe et une phase d'initialisation libre qu'un même circuit d'initialisation selon un mode de réalisation de l'invention est capable de mettre en œuvre.
La figure 6 sert à illustrer une variante de circuit d'initialisation apte à mettre en œuvre un autre mode d'initialisation dit « biaisé ».
Les figures 7A et 7B servent à illustrer les statistiques de la probabilité d'initialisation de cellules selon des modes « libre » ou « déterministe » susceptibles d'être mis en œuvre par un circuit d'initialisation selon l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un circuit d'initialisation tel que mis en œuvre suivant l'invention est intégré à un dispositif mémoire SRAM comprenant un plan mémoire M₁ formé d'au moins une colonne de cellules. Typiquement, ce plan mémoire M₁ est, comme illustré sur la figure 3, doté d'une pluralité de lignes et de colonnes de cellules SRAM.

Les cellules peuvent avoir un agencement conventionnel, ce qui implique que le circuit d'initialisation peut être implémenté sans qu'une modification de leur structure interne ne soit nécessaire. Sur la figure 2, une cellule conventionnelle SRAM Cᵢⱼ est ainsi représentée avec ses deux nœuds de stockage NT et NF, prévus pour conserver une première information logique, et une information logique complémentaire de la première information. Le maintien des informations logiques dans les nœuds est assuré par des transistors formant des inverseurs INV1, INV2 bouclés sur eux-mêmes. Par exemple, lorsque la cellule SRAM est de type communément appelé « 6T » et formée ainsi de 6 transistors, les deux inverseurs INV1, INV2, sont typiquement réalisés par deux transistors de charge et deux transistors de conduction. Les inverseurs INV1, INV2 sont connectés à une première ligne d'alimentation, en particulier une ligne d'alimentation VirVDD dite « haute », et à une deuxième ligne d'alimentation LGND, en particulier une ligne d'alimentation dite « basse ». Hors de phases durant lesquelles le circuit d'initialisation fonctionne et notamment hors de phases d'effacement mise en œuvre par ce circuit d'initialisation, la ligne d'alimentation haute VirVDD est mise à un potentiel, par exemple VDD, qui est supérieur à celui de la ligne d'alimentation basse LGND. L'accès aux nœuds de stockage NT et NF est réalisé par le biais de deux transistors d'accès TA_{T} et TA_{F} connectés respectivement à des lignes de bit BL_{T} et BL_{F} généralement partagées par les cellules SRAM d'une même colonne de cellules du plan matriciel. Cet accès aux nœuds de stockage NT et NF est commandé par une ligne de mot WL généralement partagée par les cellules SRAM d'une même ligne de cellules du plan matriciel. Les transistors d'accès TA_{T} et TA_{F} sont ainsi prévus pour permettre, lorsqu'ils sont activés de permettre l'accès au premier nœud NT et au deuxième nœud NF, ou lorsqu'ils sont désactivés de bloquer l'accès au premier nœud NT et au deuxième nœud NF.

Pour permettre d'effectuer une initialisation d'un groupe de cellules ou de l'ensemble des cellules de la mémoire, on prévoit, comme illustré sur la figure 3, un circuit d'initialisation 100 disposé en périphérie du plan matriciel M₁. Le circuit d'initialisation 100 ne requiert ici la mise en œuvre que d'un nombre restreints d'éléments additionnels périphériques au plan mémoire M₁. Le circuit d'initialisation 100 a pour particularité de pouvoir adopter différents modes de fonctionnement correspondants à différentes manières d'initialiser un groupe de cellules mémoires ou l'ensemble des cellules du plan mémoire M₁.

Un premier mode de fonctionnement permet de réaliser une initialisation déterministe INIT_D. On réalise pour cela une écriture d'au moins un groupe de cellules de la mémoire en imposant à chaque cellule de ce groupe une valeur '1' ou '0' prédéterminée. On impose ainsi un ensemble prédéterminé de valeurs prédéterminées au groupe de cellules que l'on initialise ou réinitialise.

Une manière particulière d'initialiser selon le mode d'initialisation déterministe est d'imposer un même état par exemple '1' ou '0' à toutes les cellules du groupe de cellules initialisées. En prenant comme convention que la valeur du nœud NT d'une cellule est égale à la valeur mémorisée par cette cellule, cela revient ici à écrire une valeur 1' ou '0' sur les premiers nœuds NT respectifs du groupe de cellules initialisé.

L'initialisation déterministe à une valeur imposée à chaque cellule est alors typiquement effectuée de manière simultanée entre les cellules d'un groupe de cellules initialisées. Des moyens d'activation simultanée des lignes de mots pour effectuer une activation simultanée des lignes de mot WL de manière à effectuer une sélection simultanée de lignes de cellules SRAM sont dans ce cas prévus.

La valeur prédéterminée à laquelle chaque cellule initialisée est placée peut être fixée par l'utilisateur de la mémoire ou bien par le concepteur de la mémoire.

Un mode de réalisation particulier illustré sur la figure 3 prévoit que le circuit d'initialisation 100 est configuré pour réaliser une initialisation déterministe comme mécanisme d'autoprotection par exemple pour empêcher une manipulation malveillante de la mémoire. On peut ainsi empêcher un dispositif tiers d'accéder ou détériorer des informations du dispositif mémoire, et en particulier des données d'identification ou d'authentification de la mémoire relatives au PUF (« Physically Unclonable Function ») servant de signature numérique ou d'empreinte numérique de la mémoire. On empêche ainsi que cette empreinte numérique pouvant par exemple être utilisée pour constituer une clef d'encryptage ne soit obtenue par le dispositif tiers à l'origine de la manipulation malveillante.

Ainsi, un module 110 de détection d'accès frauduleux peut être prévu pour transmettre au circuit d'initialisation 100 un signal de détection d'accès frauduleux S_{AF} permettant de déclencher son passage dans un mode de fonctionnement d'initialisation déterministe. Un tel module peut être doté de fonctions semblables à celles d'un module TAMP présent dans un microcontrôleur STM32GO commercialisé par la société STMicroelectronics et décrit dans la notice « STM32GO -TAMP, tamper and back-up registers, revision 1.0 ». Un module 120 contrôleur de PUF peut être quant à lui prévu pour transmettre au circuit d'initialisation 100 un signal S_{PUF} permettant de déclencher son passage dans un autre mode d'initialisation dit « libre », par exemple lorsque l'on souhaite obtenir une clef d'encryptage à partir de valeurs stockées dans la mémoire lorsqu'elle est initialisée par initialisation libre. Comme le module 110 de détection, le module 120 contrôleur de PUF peut être sous forme d'un circuit numérique dédié ou bien sous forme d'une fonction numérique realisée par un processeur.

Ainsi, lorsque l'on souhaite se servir du plan mémoire ou d'un groupe de cellules mémoires de ce plan une fois initialisées ou réinitialisées, pour générer une empreinte numérique ou une signature numérique, le circuit d'initialisation 100 est placé dans le mode de fonctionnement d'initialisation libre. Chaque cellule initialisée est alors mise à une valeur qui dépend de son procédé de fabrication locale et des conditions PVT (« Process », « Voltage », « Temperature », i.e. procédé, tension, température) autrement dit de procédé de fabrication globale, de niveau tensions utilisés, et de température de fonctionnement.

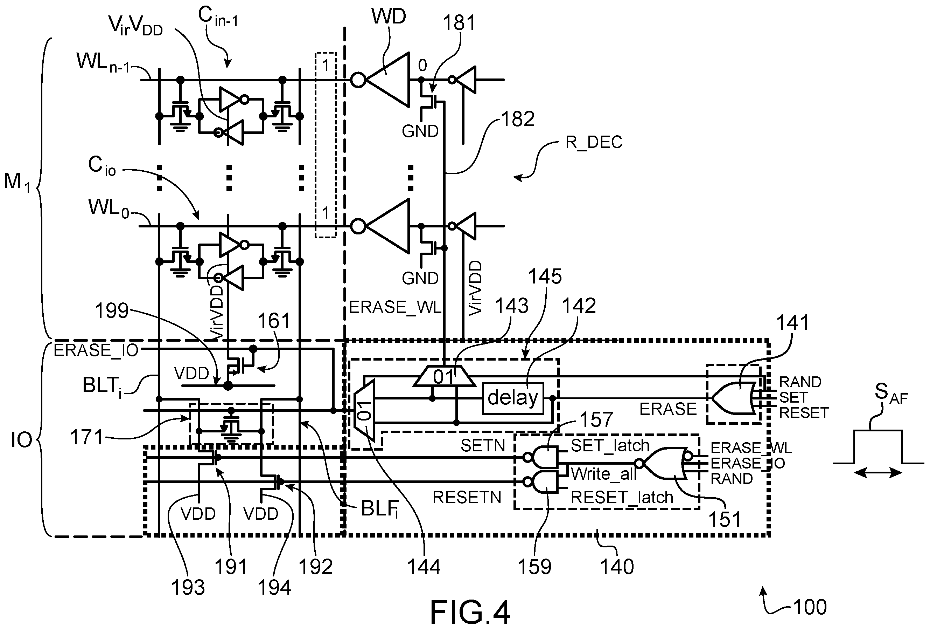

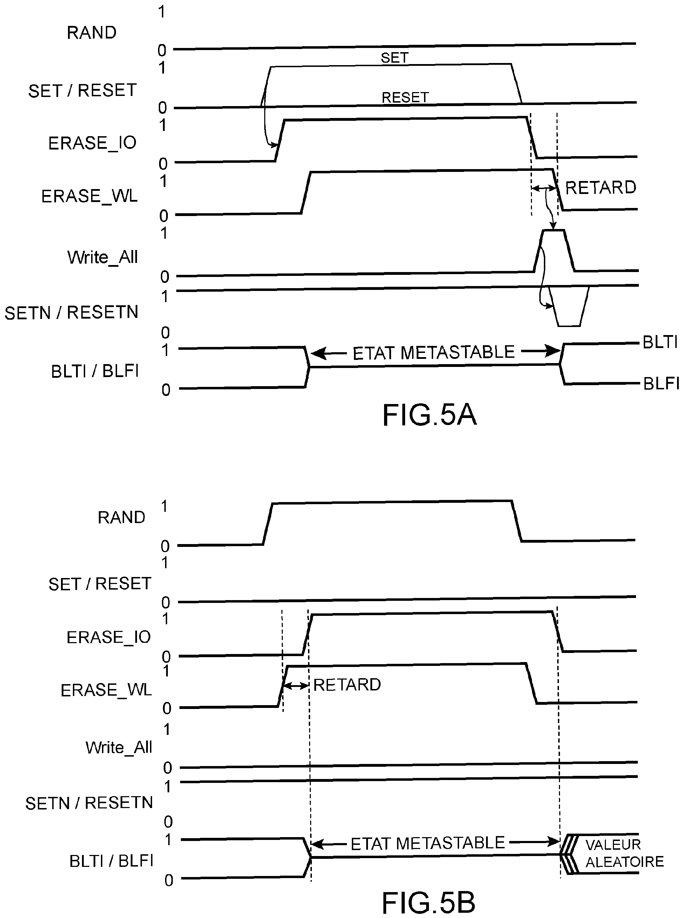

Un exemple particulier d'implémentation de circuit d'initialisation 100 capable, alternativement, d'effectuer une initialisation déterministe et une initialisation libre est illustré sur la figure 4 et va à décrit en lien avec les figures 5A, 5B.

Les chronogrammes des figures 5A, 5B sont représentatifs respectivement, d'une séquence de signaux mise en œuvre par le circuit d'initialisation 100 pour la réalisation d'une initialisation déterministe et d'une autre séquence de signaux cette fois mise en œuvre par ce même circuit d'initialisation 100 pour la mise en œuvre d'une initialisation libre.

Pour ne pas surcharger la figure 4, seule une colonne de cellules Ciₙ₋₁,...Cᵢ₀ est représentée mais le plan matriciel M₁ peut comporter plusieurs colonnes de cellules mémoires SRAM.

Le circuit d'initialisation 100 situé en périphérie du plan matriciel M₁ est ici doté d'un bloc de commande 140 logique asynchrone recevant en entrée des signaux logiques asynchrones RESET, RAND, SET, respectivement d'initialisation déterministe à zéro, de déclenchement d'initialisation libre, et de déclenchement d'initialisation déterministe à un.

Un changement d'état du signal SET de déclenchement d'initialisation déterministe peut être provoqué par exemple consécutivement à une détection d'une tentative frauduleuse d'accès à la mémoire, cette détection pouvant elle-même se traduire par l'émission ou le changement d'état d'un signal de détection d'accès frauduleux S_{AF}.

Dans l'exemple de la figure 5A, le signal SET passe en particulier à un état logique '1', ce qui déclenche tout d'abord une phase d'effacement. Le changement d'état du signal SET provoque un changement d'état d'un signal ERASE appelé « d'effacement » dont une séquence de signaux de commande ERASE_IO, ERASE_WL dépend.

Le signal d'effacement ERASE est produit en sortie d'un étage 141 du bloc de commande 140 recevant en entrée le signal SET de déclenchement d'initialisation déterministe, le signal RAND de déclenchement d'initialisation libre, le signal RESET, et réalisant une fonction OU (OR) entre ces signaux. L'étage 141 est dans l'exemple de réalisation particulier illustré, formé d'une porte logique, en particulier réalisant une fonction OU. Lors de l'effacement, la ligne d'alimentation haute VirVDD des cellules mémoires à initialiser peut être déconnectée (laissée flottante) ou mise à la masse. Elle est en tout cas découplée d'un élément de type grille ou ligne d'alimentation mise au potentiel d'alimentation VDD. Au moins un des inverseurs et avantageusement les deux inverseurs ne sont alors pas alimentés.

Pour cela, le circuit d'initialisation est avantageusement doté d'un élément interrupteur commandé par un premier signal de commande ERASE_IO et configuré pour, consécutivement à un changement d'état de ce premier signal de commande ERASE_IO, permettre de déconnecter ladite ligne d'alimentation haute VirVDD du réseau d'alimentation véhiculant un potentiel d'alimentation VDD. Dans l'exemple illustré, l'élément interrupteur est sous forme d'un transistor 161, ici de type PMOS, recevant sur sa grille le premier signal de commande ERASE_IO et disposé entre le réseau d'alimentation mis à un potentiel VDD et la ligne d'alimentation haute VirVDD.

Une phase d'effacement d'une initialisation déterministe est ici déclenchée par un signal SET ou RESET montant à un niveau logique '1'. Les signaux SET_latch, RESET-latch peuvent être des signaux de sortie de bascule d'entrées recevant respectivement les signaux SET et RESET, le signal logique RESET-latch étant complémentaire du signal logique SET_latch. Durant cette phase d'effacement d'une initialisation déterministe (signaux de la figure 5A), le premier signal de commande ERASE_IO suit la même évolution que le signal d'effacement ERASE. Le premier signal de commande ERASE_IO peut être en particulier produit en sortie d'un premier multiplexeur 144 à deux entrées '0' et '1' et dont le signal de sélection est le signal RAND de déclenchement d'initialisation libre, dans ce mode de fonctionnement désactivé et donc maintenu à un état logique '0'. Le premier multiplexeur 144 reçoit sur sa première entrée (entrée '0') le signal d'effacement ERASE et sur sa deuxième entrée (entrée '1') un signal de sortie d'un étage à retard 142, ce signal de sortie correspondant au signal d'effacement ERASE avec un retard prédéterminé. Durant la phase d'effacement, les nœuds internes NF, NT des cellules mémoires que l'on souhaite initialiser sont égalisés : ils sont mis à des potentiels égaux ou sensiblement égaux (i.e. à des valeurs qui diffèrent de moins de 10 mV). Une telle phase d'effacement permet d'implémenter plusieurs modes d'initialisation tout en limitant le nombre de composants nécessaires pour cette implémentation et en limitant la durée nécessaire pour réaliser chaque initialisation.

Dans l'exemple de réalisation particulier illustré sur la figure 4, l'égalisation des nœuds NF, NT des cellules de la i-éme colonne est réalisée en connectant ensemble les lignes de bit BLTi et BLFi et en couplant ces lignes de bit BLTi et BLFi à ces nœuds NF, NT à travers les transistors d'accès TA_{T} et TA_{F}.

Pour cela, un autre élément interrupteur formé par exemple d'un transistor 171 de type N dont l'électrode de grille est commandée par le premier signal de commande ERASE_IO peut être prévu entre les lignes de bit BLTi et BLFi. Ainsi, en fonction de l'état du premier signal de commande ERASE_IO, on peut alternativement connecter ensemble les lignes de bit BLTi et BLFi lorsqu'on souhaite réaliser un effacement, ou bien déconnecter l'une de l'autre les lignes de bit BLTi et BLFi pour permettre l'établissement des nœuds NF, NT à des valeurs respectives différentes l'une de l'autre.

Lorsque les lignes de bits BLTi et BLFi sont connectées entre elles (premier signal de commande ERASE_IO au niveau '1' sur la figure 5A), ces lignes de bits BLTi et BLFi, peuvent également être isolées de lignes de polarisation 193, 194 mises par exemple au potentiel VDD d'un circuit IO périphérique au plan mémoire et situé à une extrémité de la colonne de cellules, généralement en pied de colonne. Un élément commutateur est ainsi prévu pour permettre alternativement d'assurer le couplage ou le découplage entre la première ligne de bit BLTi et la première ligne de polarisation 193. De même, un élément commutateur est prévu pour permettre alternativement d'assurer le couplage ou le découplage entre la deuxième ligne de bit BLF et la deuxième ligne de polarisation 194. Dans l'exemple illustré, ces éléments commutateurs sont sous forme de transistors 191, 192 de couplage par exemple de type PMOS. Les grilles des transistors 191, 192 sont ici commandées respectivement par un premier signal SETN de contrôle et un autre signal RESETN de contrôle.

Dans l'exemple de réalisation illustré, les signaux SETN et RESETN de contrôle sont des signaux de sorties respectivement d'un premier bloc logique 157 réalisant une fonction logique NON ET (NAND) et d'un deuxième bloc logique 159 réalisant une fonction NAND. Le premier bloc logique 157 a ici une entrée contrôlée par le signal logique SET_latch tandis que le deuxième bloc logique 159 a une entrée contrôlée par le signal logique RESET-latch complémentaire du premier signal logique SET_latch.

Les deux blocs logiques 157, 159 ont également une entrée commune contrôlée par un signal Write_all de déclenchement d'écriture simultanée, lui-même dépendant d'un deuxième signal de commande ERASE_WL, du premier signal de commande ERASE_IO et du signal RAND de déclenchement d'initialisation libre. Dans l'exemple de réalisation particulier illustré, le signal Write_all de déclenchement d'écriture simultanée est produit en sortie d'un bloc 151 réalisant une fonction NON OU (NOR) et recevant en entrée un signal not(ERASE_WL) complémentaire du deuxième signal de commande signal ERASE_WL, le premier signal de commande ERASE_IO et le signal de déclenchement RAND.

Pour permettre de réaliser une sélection simultanée de plusieurs lignes de cellules du plan matriciel, des moyens ou un étage sélection intégré(s) à un décodeur de ligne R_DEC du plan mémoire comprennent une ligne 182 supplémentaire prévue pour acheminer le deuxième signal de commande ERASE_WL servant de signal de sélection simultanée de lignes de mots. A chaque partie du décodeur de ligne R_DEC associé à une ligne de cellules de la matrice, on prévoit un transistor 181, dont la grille est connectée à la ligne 182 supplémentaire portant le signal de commande ERASE_WL.

Le transistor 181, dont la grille est commandée par le signal ERASE_WL, est connecté à l'entrée d'un circuit inverseur WD situé en sortie du décodeur de ligne R_DEC. Dans l'exemple de réalisation illustré, le transistor 181 est de type N et la sélection simultanée est ici réalisée lorsque le deuxième signal de commande ERASE_WL acheminé sur la ligne 182 supplémentaire est mis à un niveau '1' logique. Le deuxième signal de commande ERASE_WL peut être en particulier produit en sortie d'un deuxième multiplexeur 143 à deux entrées '0' et '1' et dont le signal de sélection est le signal RAND de déclenchement d'initialisation libre. Le deuxième multiplexeur 143 reçoit sur sa première entrée (entrée '0') le signal de sortie de l'étage 142 à retard, ce signal de sortie correspondant au signal d'effacement ERASE avec un retard prédéterminé. Les multiplexeurs 144, 143 sont ainsi commandés par un même signal de sélection et ont des entrées inversées l'un par rapport l'autre, de sorte que la première entrée du premier multiplexeur est reliée à la deuxième entrée du deuxième multiplexeur tandis que la deuxième entrée du premier multiplexeur est reliée à la première entrée du deuxième multiplexeur. Avec une telle configuration des multiplexeurs 144, 143 et l'étage 142 à retard, on peut produire ainsi un bloc 145 qui, en fonction du signal de déclenchement RAND, produit des séquences différentes de signaux de commande ERASE_IO d'égalisation des lignes de bits et du couplage/découplage de la ligne d'alimentation, et ERASE_WL de commande de sélection simultanée suivant que l'on soit dans un mode d'initialisation ou l'autre.

Un nouveau changement d'état du signal SET (dans l'exemple de la figure 5A passage à nouveau l'état logique '0') de déclenchement d'initialisation déterministe termine la phase d'effacement et entraine un changement d'état du premier signal de commande ERASE_IO, de manière à découpler entre eux le premier nœud NT et le deuxième nœud NF en déconnectant ici la première ligne de bit BLTi de la deuxième ligne de bit BLFi. Le changement d'état du premier signal de commande ERASE_IO permet également de rétablir l'alimentation des cellules en connectant à nouveau, par l'intermédiaire du transistor 161 rendu passant, la ligne d'alimentation haute virVDD à la grille d'alimentation mise au potentiel d'alimentation VDD.

Dans l'exemple illustré sur les figures 4 et 5A, le passage à l'état '0' du premier signal de commande ERASE_IO déclenche également un passage à l'état '1' du signal Write_All d'écriture simultanée. Ce passage à l'état '1' du signal Write_All d'écriture simultanée provoque un changement d'état du signal SETN de contrôle, ici activé ou mis à un état logique '0', de manière à coupler la première ligne de bit BLTi à la ligne de polarisation 193 au potentiel d'alimentation VDD. La deuxième ligne de bit BLFi reste quant à elle découplée de la ligne de polarisation 194 dans la mesure où l'autre signal RESETN de contrôle est maintenu dans le même état logique '1'.

Tant que le deuxième signal de commande ERASE_WL est maintenu à l'état '1', ce qui permet de maintenir les transistors d'accès activés, en créant un déséquilibre de polarisation entre la première ligne de bit et la deuxième ligne de bit, on force ainsi l'écriture simultanée d'une donnée, ici une valeur '1' dans les nœuds NT de toutes les cellules dont la ligne de mot a été activée. La durée de l'écriture simultanée dépend et peut être en particulier égale au retard prédéterminé imposé par l'étage 142. Au retour du signal Write_All à l'état '0', la phase est conclue, est l'opération à peine effectuée (SET ou RESET) reste mémorisée dans les signaux SET_LATCH et RESET_LATCH.

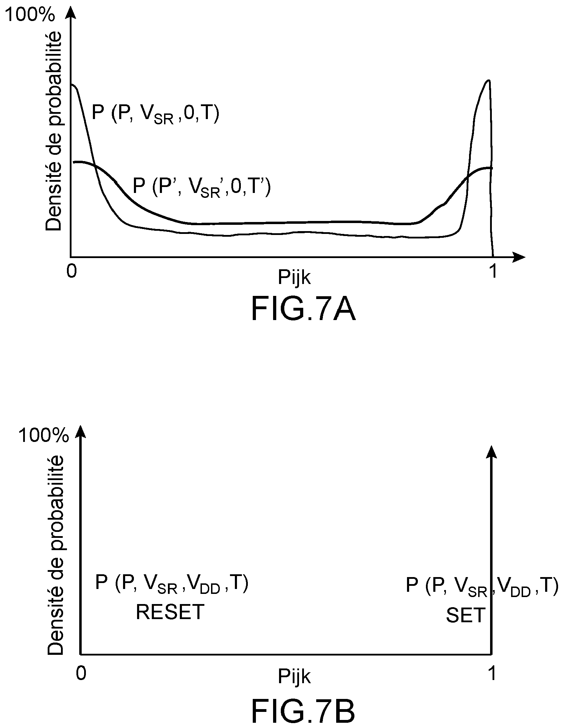

Dans le mode d'initialisation déterministe, la probabilité qu'une cellule mémoire s'initialise à 1 est égale à 1 si on fait un SET : *p(P, V_{SR}, VDD, T)* de la Figure 7B a donc un seul pic sur la valeur '1'. La probabilité qu'une cellule s'initialise à 0 est égale à 1 si on fait un RESET : *p(P, V_{SR}, -VDD, T)* a donc un seul pic sur la valeur '0'.

La phase d'effacement d'une initialisation libre est déclenchée par un signal RAND montant à un niveau logique '1', exemple illustré sur la figure 5B. Le changement d'état du signal de déclenchement RAND déclenche tout d'abord ici également une phase d'effacement. Un changement d'état du signal d'effacement ERASE en sortie de la l'étage 141, entraine lui-même un changement d'état du deuxième signal de commande signal ERASE_WL permettant une sélection simultanée des lignes de mot.

Le premier signal de commande ERASE_IO est cette fois retardé par rapport au deuxième signal de commande ERASE_WL du retard prédéterminé imposé par l'étage à retard 142. Un changement d'état du premier signal de commande ERASE_IO faisant suite à celui du deuxième signal de commande signal ERASE_WL entraine une déconnexion de la ligne haute d'alimentation virVDD des cellules et une égalisation (« ETAT METASTABLE » de signaux BLTi, BLFi respectivement de lignes de bits d'une i-ème colonne sur la figure 5B) des valeurs de potentiel du premier nœud NT et du deuxième nœud NF, là encore par le biais d'une connexion entre elles des lignes de bits BLTi et BLFi tandis que les transistors d'accès sont activés. Lors de l'égalisation des nœuds NF, NT par connexion des lignes de bits BLTi et BLFi, ces dernières sont isolées de lignes de polarisation 193, 194 supplémentaires. Les signaux SETN et RESETN de contrôle sont d'ailleurs ici maintenus désactivés (i.e. à '1') de manière à découpler les lignes de bits BLTi et BLFi, des lignes de polarisation 192, 193 supplémentaires durant toute la durée du mode de fonctionnement d'initialisation libre. Lors de la phase d'effacement, la ligne haute d'alimentation virVDD est découplée d'un élément 199 tel qu'une grille d'alimentation ou une ligne d'alimentation au potentiel d'alimentation VDD. Ce découplage est réalisé ici au moyen d'un transistor 161 rendu bloqué. Le premier inverseur INV1 et le deuxième inverseur INV2 ne sont alors pas alimentés.

Un nouveau changement d'état du signal RAND de déclenchement (dans l'exemple de la figure 5B passage à nouveau à l'état logique '0') entraine un changement d'état du deuxième signal de commande ERASE _WL, qui entraine la fin de la sélection simultanée des lignes de mots, puis, un changement d'état du premier signal de commande ERASE_IO. Ce changement d'état, ici la mise à '0' du premier signal de commande ERASE_IO entraine la fin de la phase de pré-initialisation et de l'égalisation des nœuds. Cela déclenche une déconnexion des lignes de bits BLTi et BLFi l'une de l'autre. Ce changement d'état du premier signal de commande ERASE_IO, provoque également une reconnexion de la ligne d'alimentation haute VirVDD des cellules à une grille d'alimentation. La ligne d'alimentation haute VirVDD est alors rétablie à un potentiel d'alimentation VDD. Le premier inverseur INV1 et le deuxième inverseur INV2 sont alors alimentés.

Les cellules sont ainsi à nouveau alimentées et leurs transistors d'accès sont alors typiquement désactivés. Chaque cellule peut alors individuellement basculer à une valeur '1' ou '0' (correspondant par exemple par convention à un état logique '1' ou '0' de leur premier nœud NT) d'une manière libre ou aléatoire, mais qui suit la statistique *ρ(V*_{*SR*,} *0, T)* fonction des variations locales et des conditions d'opérations propres de cette cellule et de la puce à qui elle appartient. Ainsi, certaines cellules sont alors mises à un état logique '1' tandis que d'autres sont mises à un état logique '0'.

L'exemple de réalisation qui vient d'être donné et dans lequel on effectue l'égalisation des nœuds par connexion des lignes de bits entre elles lors de la phase d'effacement permet de réaliser une initialisation plus rapide et moins consommatrice qu'une simple mise à la masse des nœuds de stockage.

Dans l'exemple de réalisation qui vient d'être décrit, suite à l'effacement complet d'un groupe de cellules ou de mémoire la SRAM en égalisant les nœuds internes à une valeur identique lors de la phase d'effacement, on configure de manière libre ou déterministe son nouveau contenu. Le circuit d'initialisation permet d'utiliser alternativement l'une ou l'autre de ces deux techniques tout en limitant le nombre de composants nécessaires et la consommation engendrée par l'initialisation.

Outre le fait de permettre d'effectuer différents types d'initialisation, le circuit d'initialisation permet également d'accélérer l'écriture déterministe de l'ensemble ou d'un sous ensemble de la mémoire à une valeur fixée par l'utilisateur ou le concepteur de la mémoire, grâce à la présence et au procédé de commande des transistors reliés aux réseaux d'alimentation 191 et 192.

Toutefois, en variante ou en combinaison de l'exemple de réalisation décrit précédemment, la phase d'effacement lors de laquelle on égalise le premier nœud NT et le deuxième nœud NF de chaque cellule peut être réalisée en forçant les lignes de bits à la masse.

Alternativement, il est possible d'utiliser des cellules mémoire non conventionnelles 6T, qui incluent, comme représenté en figure 1B, un transistor d'effacement T₁ bien que cela soit moins avantageux en termes de compacité et de densité d'intégration. Dans ce cas, l'effacement ne nécessite plus d'avoir le transistor 171 en pied de colonne. La logique de commande peut alors être adaptée pour commander la conduction des transistors d'effacement dans chaque cellule grâce à un signal de commande de ces transistors d'effacement qui peut être similaire à celui du signal ERASE_IO. L'activation du signal ERASE_WL n'est alors plus nécessaire dans cette phase d'effacement et il est éventuellement possible de s'affranchir de la présence de ce signal ERASE_IO avec les transistors 181 associés. L'intérêt éventuel de conserver ces derniers réside dans la mise en œuvre de l'initialisation pour pouvoir conduire une initialisation déterministe ou libre sur une pluralité de lignes de cellules mémoire simultanément. De même, dans l'exemple qui vient d'être donné, pour permettre l'initialisation déterministe on applique lors de la deuxième phase suivant l'effacement, un potentiel égal à VDD sur l'une des lignes de bits tandis que l'autre ligne de bit reste flottante. On peut en variante envisager une autre manière de polariser les lignes de bits ou un autre écart de polarisation entre les lignes de bits.

Selon une première option, on peut utiliser des transistors NMOS reliés à des lignes de masse à la place de transistors PMOS reliés à des lignes d'alimentation 193 et 194 mises à VDD.

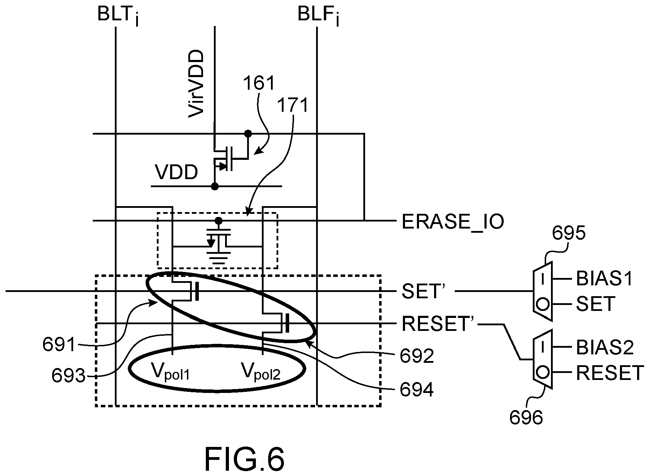

Selon une deuxième option, on effectue un réglage « analogique » du courant ou de la tension à imposer sur l'une ou l'autre des lignes de bits lors de la deuxième phase d'initialisation, en particulier en appliquant un courant ou une tension sur la ligne de bits intermédiaire par rapport à celle (celui) appliqué lorsque la ligne de bit est couplée à la masse ou au potentiel d'alimentation VDD, et ce, afin d'obtenir un tirage aléatoire associé à une probabilité différente d'une probabilité « standard » définie lorsqu'on applique un potentiel d'alimentation VDD ou la masse GND. Un mode de réalisation particulier de cette deuxième option sera décrit ultérieurement en liaison avec la figure 6.

Dans l'exemple de réalisation décrit précédemment en liaison avec les figures 4, 5A, 5B, pour effectuer l'effacement, par égalisation des nœuds par couplage par connexion des lignes de bits entre elles, on réalise une sélection simultanée des cellules en activant au moins plusieurs lignes de mots et par conséquent les transistors d'accès d'au moins plusieurs rangées de cellules. En variante, en particulier lorsque l'on effectue l'égalisation des nœuds par connexion des nœuds entre eux, on peut prévoir de conserver désactivées les lignes de mots des rangées de cellules que l'on souhaite initialiser. Les transistors d'accès des cellules appartenant à ces rangées sont alors maintenus désactivés pour bloquer l'accès à la cellule et découpler celle-ci des lignes de bits.

On peut prévoir de réaliser un mode d'initialisation intermédiaire et distinct du mode d'initialisation libre et du mode d'initialisation déterministe décrits précédemment.

Un tel mode d'initialisation « partiellement déterministe » encore appelé « biaisé » peut être utilisé afin par exemple d'accélérer une phase de recherche (« enrollment » selon la technologie anglo-saxonne) de cellules mémoires fortement biaisés, c'est-à-dire qui, lorsqu'elles sont initialisées, s'initialisent préférentiellement selon une valeur '1' ou '0' dans des conditions de température et de tension variant dans une gamme donnée.

Si l'on considère maintenant comment la statistique *p(P, V_{SR}, ΔV, T)* dépend de la tension appliquée entre les lignes de bits BLTi, BLFi, on ne voit dans les figures 7A-7B que des statistiques pour *ΔV=-VDD* (initialisation déterministe RESET, pic de gauche dans la figure 7B), *ΔV=0* (initialisation libre, double pic dans la figure 7A) et *ΔV=VDD* (initialisation déterministe SET, pic de droite dans la figure 7B). Un tel mode d'initialisation « biaisé » permet de réaliser une initialisation qui aura une statistique intermédiaire entre ces cas extrêmes, et donc d'altérer l'initialisation libre en favorisant l'état '0' si *ΔV<0* ou plutôt l'état '1' si *ΔV>0.* Les valeurs de tension appliquées sur les lignes de bits BLTi, BLFi nous permettent donc de contrôler la statistique d'initialisation.

Ce mode d'initialisation « partiellement biaisé » peut être mis en œuvre en introduisant un déséquilibre de conductivité entre les transistors agencés entre la ligne de bit d'une ligne de polarisation. Ce déséquilibre, modulable en fonction du biais que l'on souhaite introduire, peut être ajusté en adaptant le dimensionnement respectif des transistors, et en particulier leur rapport W/L (rapport de la largeur sur la longueur du canal) soit en adaptant leurs polarisations respectives, soit par une combinaison de ces deux types d'adaptations.

Ainsi, sur la figure 6, une variante de réalisation permettant d'implémenter en outre une initialisation « biaisée » est illustrée. La probabilité qu'une cellule s'initialise à « 0 » ou « 1 » peut être dans cet exemple de réalisation modulée en fonction des valeurs respectives de signaux SET', RESET', vpol1, vpol2 appliqués sur des transistors de couplage 691, 692 reliés aux lignes de bits BLTi, BLFi.

Entre la première ligne de bit BLTi et une première ligne de polarisation 693 mise à un premier potentiel de polarisation Vpol1, un transistor 691 de couplage est prévu, ce transistor 691 étant cette fois de type NMOS et doté d'une grille contrôlée par le signal SET'. Ce signal SET' peut prendre la valeur du signal SET, lorsque l'on souhaite effectuer une initialisation déterministe ou libre. Ce signal SET' peut en revanche prendre la valeur d'un signal de polarisation BIAS1, lorsque l'on souhaite effectuer une initialisation biaisée. Pour pouvoir alternativement appliquer le signal SET ou BIAS1 sur la grille du transistor de couplage 691 on peut par exemple prévoir un multiplexeur 695 dont les entrées sont les signaux SET et BIAS1 et qui délivre en sortie le signal SET'.

De même, un transistor 692 de couplage, ici également de type NMOS, et doté d'une grille contrôlée par le signal RESET', est prévu entre la deuxième ligne de bit BLF et une deuxième ligne de polarisation 694 mise à un deuxième potentiel de polarisation Vpol2. Ce signal RESET' peut prendre la valeur du signal RESET, lorsque l'on souhaite effectuer une initialisation déterministe ou libre. Ce signal peut prendre la valeur d'un autre signal de polarisation BIAS2, lorsque l'on souhaite effectuer une initialisation biaisée. Pour pouvoir alternativement appliquer le signal RESET ou BIAS2 sur la grille du transistor de couplage 692, on peut par exemple prévoir un multiplexeur 696 dont les entrées sont les signaux RESET et BIAS2 et qui délivre en sortie le signal RESET'.

Pour permettre de basculer entre les différents modes d'initialisation déterministe, libre ou biaisé, on peut prévoir en remplacement de l'étage 141 décrit précédemment, un circuit logique (non représenté), recevant en entrée les signaux RAND, SET, RESET, et un signal binaire supplémentaire JOK. Ainsi, un changement d'état du signal binaire supplémentaire JOK détermine un déclenchement d'initialisation biaisée. Avantageusement, le premier transistor 691 peut être prévu avec un rapport W1/L1 différent de celui W2/L2 du deuxième transistor 692. Tandis que dans l'exemple décrit précédemment en lien avec la figure 4, on choisit typiquement des transistors de taille importante, on peut prévoir ici des transistors 691, 692 de faible taille.

On prévoit avantageusement ces potentiels Vpol1, Vpol2 égaux à *ΔV,* avec *ΔV*<< VDD, VDD étant le potentiel d'alimentation VDD. Par *ΔV*<< VDD (*ΔV* très inférieur à VDD) on entend que *ΔV* est au moins inférieur à VDD/10 et avantageusement inférieur à VDD/Y Avec un l'agencement donné sur la figure 6, on peut mettre en œuvre un mode d'initialisation biaisé dans lequel on réalise dans une première phase, une opération d'effacement selon une technique mentionnée précédemment.

Selon une deuxième phase, on assure, comme pour une initialisation déterministe, une polarisation différente entre la première ligne de bit BLTi et la deuxième ligne de bit BLFi tout en activant le premier transistor d'accès et le deuxième transistor d'accès des cellules initialisées. Un des deux signaux de polarisation BIAS1, BIAS2 est mis à VDD tandis que l'autre des deux signaux de polarisation SET'=BIAS1, RESET'=BIAS2 est à VDD-ΔV. Avantageusement, lors de la deuxième phase, les signaux SET'=BIAS1, et RESET'=BIAS2 peuvent être prévus de sorte qu'il n'y a qu'un seul des deux transistors 691, 692 qui est rendu conducteur. Ce transistor 691 ou 692 rendu conducteur est en régime sous le seuil ou linéaire ou saturé. Toutefois, le niveau de tension ou courant imposé à la ligne de bit couplée au transistor rendu conducteur est différent de celui permettant d'imposer un état donné avec un niveau de probabilité proche de '1' de sorte que le niveau auquel vont s'établir les cellules initialisées reste aléatoire.

La différence de polarisation entre les lignes de bits est cette fois effectuée en maintenant l'écart de polarisation entre les deux lignes de bits à un niveau ΔV faible et très inférieur au potentiel d'alimentation VDD afin de biaiser la tendance des nœuds NT et NF à basculer vers une valeur logique ou un état donné sans toutefois l'imposer. La valeur de *ΔV* peut être modulée en fonction du biais que l'on souhaite introduire. En modifiant cette valeur, on modifie la probabilité qu'à une cellule de s'établir à un niveau '1' ou '0'.

Avec un dispositif tel qu'illustré sur la figure 6, on peut effectuer une succession de tests d'initialisation avec des valeurs différentes des potentiels de polarisation Vpol1, Vpol2. On peut ainsi moduler le potentiel ΔV d'une initialisation à l'autre. Cela peut être utile pour permettre de vérifier la probabilité qu'a une cellule de basculer vers un état logique '1' ou '0' lorsque l'initialisation n'est pas déterministe.

Ainsi, lors d'une première initialisation au moins une ligne de polarisation donnée parmi les lignes de polarisation 691, 693 est mise à un potentiel de polarisation donné *ΔV*=*ΔV₁,* avec *ΔV₁* < VDD/10, puis lors d'une deuxième étape d'initialisation ladite ligne de polarisation donnée 691, 693 est mise à un potentiel de polarisation ΔV= *ΔV₂, ΔV₁≠ ΔV₂* et tel que *ΔV₂* < VDD/10.

La suite complète des valeurs ΔVᵢ peut être déterminée par un algorithme, de manière à sélectionner les cellules plus fortement biaisées. Une détection de cellules fortement biaisées peut être ainsi mise en œuvre.

En effet, selon le niveau de tension et de courant de polarisation appliqué sur la ou les lignes de bits lors de l'initialisation, le déséquilibre introduit entre les nœuds NT et NF d'une cellule est différent. Entre un cas où les deux lignes de bits sont toutes deux polarisées à Vdd avec une capacité de courant similaire conduisant à un déséquilibre initial nul entre les deux nœuds, et un cas opposé où les lignes de bits sont polarisées avec une dissymétrie de tension et de courant possible, il y a un panel de déséquilibres en tension ou en courant possibles.

Dans le cas par exemple où on réalise plusieurs tests consistant chacun en un cycle d'effacement/ initialisation libre/ lecture, en utilisant une initialisation biaisée, on peut chercher à identifier certaines cellules qui ne commutent pas de la même manière que la majorité ou la très grande majorité des autres. On peut dire de ces autres cellules « résistantes » qu'elles ont intrinsèquement un biais d'initialisation *pᵢⱼₖ* tel que, lorsqu'on utilise une initialisation libre symétrique, il est très fortement probable qu'elles prennent quasiment toujours la même valeur. Autrement dit, de telles cellules « résistantes » ont une probabilité *pᵢⱼₖ* proche de 1 ou de 0 (selon le sens de la dissymétrie appliquée sur les lignes de bits) de prendre une valeur donnée, par exemple la valeur 1, lors d'une initialisation libre symétrique.

Lorsque la probabilité *pᵢⱼₖ* qu'une cellule donnée s'initialise à une valeur '1' est très proche de 0 ou 1, elle peut être avantageusement utilisée pour établir une signature numérique. Ainsi, si les cellules retenues pour réaliser cette signature numérique s'initialisent quasiment toujours à la même valeur, avec une très grande probabilité, statistiquement le code numérique obtenu par lecture de ces cellules après initialisation sera pour quasi toujours le même.

Selon une variante d'utilisation de la mémoire, il est possible de rechercher les cellules mémoire présentant une probabilité 0,5 ou autre valeur pouvant être différente des valeurs extrême proches de 0 ou de 1. Pour ce faire, on réalise des tests des cellules mémoires avec une initialisation libre avec une dissymétrie nulle ou donnée dans les polarisations. On peut alors répertorier pour chaque cellule quel est sa probabilité *pᵢⱼₖ* de prendre une valeur donnée, par exemple '1', pour chaque niveau de dissymétrie en fonction du biais de polarisation.

Lorsque la probabilité *pᵢⱼₖ* qu'une cellule donnée s'initialise à une valeur '1' est centrée sur 0,5, elle peut être avantageusement utilisée pour générer, lors d'une initialisation libre, un nombre binaire aléatoire à entropie maximale, présentant donc une égale probabilité 0,5 de ressortir la valeur 1 ou 0. Alternativement, si l'on souhaite générer un nombre aléatoire avec une probabilité autre que 0,5 et asymétrique entre les deux valeurs 1 et 0, et donc a entropie non maximale, on peut mettre en œuvre une initialisation libre avec introduction d'un biais de polarisation permettant d'avoir la probabilité souhaitée.

Avec une telle implémentation, un gain significatif en temps de test des cellules est obtenu. Elle permet de réduire fortement le nombre de cycles de mise en tension de la mémoire/ lecture / effacement, pour permettre d'identifier des cellules mémoires fortement déséquilibrées et dont la probabilité d'initialisation est proche de 0 ou 1 ou très bien équilibrées et dont la probabilité d'initialisation est proche de 1/2 ou encore présentant une autre valeur de probabilité d'initialisation.

Une implémentation telle que décrite précédemment en lien avec la figure 6 est particulièrement favorable à l'implémentation au sein d'un même circuit, d'une mémoire, d'un générateur de nombre aléatoire et d'un module de calcul en mémoire (IMC pour « In Memory Computing ») en particulier permettant de réaliser une certaine fonction telle qu'une fonction MAC (pour « multiply-and-Accumulate », i.e. « multiplie puis accumule »).

On pourra enfin combiner l'activation de plusieurs cellules d'une même colonne de manière à atteindre plus facilement des probabilités visées. A titre d'exemple, 2 cellules mémoires avec des probabilités de 0.1 chacune présenteraient une probabilité combinée d'une valeur bien inférieure à 0.1.

Un dispositif tel que mis en œuvre suivant l'un ou l'autre des modes de réalisation décrits précédemment peut trouver des applications notamment dans des systèmes embarqués, dans des systèmes de calcul haute performance HPC pour (« High Performance Computing ») et/ou de chiffrement tels que les systèmes AES (pour « Advanced Encryption Standard », i.e. « norme de chiffrement avancé ») des systèmes de cryptomonnaies.

## Revendications

1. Dispositif de mémoire statique à accès aléatoire comprenant une matrice mémoire (M₁) dotée d'au moins un ensemble de cellules mémoires SRAM chacune desdites cellules dudit ensemble comprenant :
- un premier nœud (NT) de stockage et un deuxième nœud (NF) de stockage,
- un premier inverseur (INV1) et un deuxième inverseur (INV2) connectés de façon croisée entre ledit premier nœud et ledit deuxième nœud, le premier inverseur et/ou le deuxième inverseur étant connectés à une ligne d'alimentation (VirVdd) dite « haute » pouvant être mise à un potentiel d'alimentation (VDD) et à une ligne d'alimentation (LGND) dite « basse » pouvant être mise à un potentiel de référence (GND),
- un premier transistors d'accès (TA_{T}) au premier nœud de stockage et un deuxième transistor d'accès (TA_{F}) au deuxième nœud de stockage, le premier transistor d'accès et le deuxième transistor d'accès étant respectivement connectés à une première ligne de bit (BL_{T}) et à une deuxième ligne (BL_{F}), la première ligne de bit et la deuxième ligne de bit étant partagée par lesdites cellules de ladite colonne, une activation ou une désactivation des transistors d'accès étant commandée par une ligne de mot (WL),
le dispositif étant doté en outre d'un circuit d'initialisation (100) de cellules dudit ensemble configuré pour, selon un premier mode d'initialisation,
- selon une première phase dite d'effacement : placer le premier nœud (NT) et le second nœud (NF) d'au moins un groupe de cellules mémoires à des potentiels égaux l'un de l'autre ou sensiblement égaux l'un de l'autre, puis,
- selon une deuxième phase, polariser la première ligne de bit (BLT) différemment de la deuxième ligne de bit (BLF) tout en activant le premier transistor d'accès et le deuxième transistor d'accès des cellules dudit groupe,
le circuit d'initialisation (100) étant configuré en outre pour, selon un deuxième mode d'initialisation,
- selon une première phase dite d'effacement, placer le premier nœud (NT) et le second nœud (NF) d'au moins un groupe de cellules à des potentiels égaux puis après la première phase :
- selon une deuxième phase, désactiver le premier transistor d'accès (TA_{T}) et le deuxième transistor d'accès (TA_{F}) des cellules dudit groupe tout en mettant la ligne d'alimentation haute (VirVdd) au potentiel d'alimentation (VDD) afin d'alimenter le premier inverseur et le deuxième inverseur.

2. Dispositif selon la revendication 1, dans lequel lors de la phase d'effacement, le premier nœud (NT) et le second nœud (NF) sont placés à des potentiels égaux ou sensiblement égaux l'un de l'autre, en connectant entre elles ladite première ligne de bit (BLT) et ladite deuxième ligne de bit (BLF), le circuit d'initialisation (100) étant doté en outre : d'un élément interrupteur, en particulier un transistor (171), configuré pour alternativement connecter entre elles et déconnecter l'une de l'autre la première ligne de bit (BL_{T}) et la deuxième ligne de bit (BL_{F}), ledit élément interrupteur (171) étant commandé par un premier signal de commande (ERASE_IO), de sorte à déconnecter l'une de l'autre la première ligne de bit (BLT) et la deuxième ligne de bit (BLF) lors de ladite deuxième phase du premier mode d'initialisation et du deuxième mode d'initialisation.

3. Dispositif selon la revendication 2, le circuit d'initialisation (100) est doté en outre d'un autre élément interrupteur, en particulier un autre transistor (161), configuré pour alternativement découpler la ligne d'alimentation (VirVDD) dite « haute » à une alimentation lors de la phase d'initialisation et pour coupler la ligne d'alimentation (VirVDD) « haute » et ladite alimentation lors de la deuxième phase, l'autre élément interrupteur (161) étant commandé par ledit premier signal de commande (ERASE_IO).

4. Dispositif selon l'une des revendications 2 ou 3, dans lequel la matrice (M₁) est agencée en outre en rangées d'une ou plusieurs cellules SRAM et dans lequel une pluralité de ligne de mot (WL₀,...,WLₙ₋₁) sont connectées respectivement à ladite pluralité de cellules mémoires SRAM de ladite colonne, chaque ligne mot permettant, lorsqu'elle est activée, de sélectionner la ou les cellules mémoires d'une rangée donnée de cellules SRAM parmi lesdites rangées de cellules SRAM, le circuit d'initialisation (100) comprenant en outre un étage (WD, 181, 143) d'activation simultanée desdites lignes de mots pour, lors de la deuxième phase dudit premier mode d'initialisation, effectuer, par le biais d'un deuxième signal de commande (ERASE_WL), maintenir une activation simultanée desdites lignes de mots dudit groupe de cellules.

5. Dispositif selon l'une des revendications 1 à 4, dans lequel le circuit d'initialisation (100) comprend :
- une première ligne de polarisation (193, 693) apte, lorsqu'elle est couplée à la première ligne de bit (BLT) à imposer un premier potentiel de polarisation (VDD, Vpol1) ou un premier courant de polarisation à la première ligne de bit (BLT),
- un premier transistor (191, 691) de couplage entre la première ligne de polarisation (193, 693) et la première ligne de bit (BLT) commandé par un premier signal de contrôle (SETN, SET'),
- une deuxième ligne (194, 694) de polarisation apte, lorsqu'elle est couplée à la deuxième ligne de bit (BLF) à imposer un deuxième potentiel de polarisation (VDD, Vpol2) ou un deuxième courant de polarisation à la deuxième ligne de bit,
- un deuxième transistor (192, 692) de couplage agencé entre la deuxième ligne de polarisation (194, 694) et la deuxième ligne de bit et commandé par un deuxième signal de contrôle (RESETN, RESET').

6. Dispositif selon la revendication 5, dans lequel le premier transistor de couplage est prévu pour alternativement coupler la première ligne de polarisation (193) à la première ligne de bit ou découpler la première ligne de polarisation (193) de la première ligne de bit, le deuxième transistor de couplage étant prévu pour alternativement coupler la deuxième ligne de polarisation (194, 694) à la deuxième ligne de bit ou découpler la deuxième ligne de polarisation (194, 694) de la deuxième ligne de bit, de sorte que :
lors de la phase d'effacement du premier mode d'initialisation et du deuxième mode d'initialisation : la première ligne de polarisation (193) et la deuxième de polarisation sont découplées respectivement de la première ligne de bit et de la deuxième ligne de bit,
lors de la deuxième phase du premier mode d'initialisation : la première ligne de polarisation est couplée à la première ligne de bit tandis que la deuxième ligne de polarisation est découplée de la deuxième ligne de bit ou bien la première ligne de polarisation est découplée de la première ligne de bit tandis que la deuxième ligne de polarisation est couplée à la deuxième ligne de bit,
lors de la deuxième phase du deuxième mode d'initialisation, la première ligne de polarisation est découplée de la première ligne de bit tandis que la deuxième ligne de polarisation est découplée de la deuxième ligne de bit.

7. Dispositif selon l'une des revendications 1 à 6, dans lequel lors de la deuxième phase du premier mode d'initialisation l'une desdits première ligne de bit (BLT) et deuxième ligne de bit (BLF) est mise au potentiel d'alimentation (VDD) tandis que l'autre desdits première ligne de bit (BLT) et deuxième ligne de bit (BLF) est laissée flottante ou mise à la masse (GND) ou à un potentiel inférieur au potentiel de référence servant de masse.

8. Dispositif selon l'une des revendications 5 à 7, dans lequel la première ligne de polarisation (193) et la deuxième ligne de polarisation (194) sont mises au potentiel d'alimentation (VDD).

9. Dispositif selon la revendication 5 ou 6, dans lequel le premier transistor (691) de couplage a une taille W1/L1 et dans lequel le deuxième transistor de couplage (692) a une taille W2/L2 différente de celle du premier transistor de couplage (691) et/ou dans lequel au moins l'un desdits premier potentiel de polarisation (Vpol1) et deuxième potentiel de polarisation (Vpol2) est prévu à une valeur ΔV telle que :
GND < ΔV < VDD et en particulier telle que GND < ΔV < VDD/10.

10. Dispositif selon l'une des revendications 1 à 9, dans lequel le circuit d'initialisation (100) est doté d'un bloc de commande logique (140) apte à recevoir un premier signal de déclenchement (SET) du premier mode d'initialisation et un signal de déclenchement (RAND) du deuxième mode d'initialisation et à produire consécutivement à la réception du premier signal de déclenchement (SET) une première séquence de signaux de commande (ERASE_WL, ERASE_IO), mettant le circuit d'initialisation (100) dans le premier mode d'initialisation et à produire consécutivement à la réception du deuxième signal de déclenchement (SET), une deuxième séquence desdits signaux de commande (ERASE_WL, ERASE_IO), distincte de la première séquence et mettant le circuit d'initialisation (100) dans le deuxième mode d'initialisation.

11. Dispositif selon la revendication 9, dans lequel parmi lesdits signaux de commande (ERASE_WL, ERASE_IO) figure :
- un premier signal de commande (ERASE_IO) pour, lorsque le premier signal de commande (ERASE_IO) est dans un premier état, commander une connexion des lignes de bits entre elles et une déconnexion entre la ligne d'alimentation haute et ladite alimentation et lorsque le premier signal de commande (ERASE_IO) est dans un deuxième état commander une déconnexion des lignes de bits l'une de l'autre et une connexion de la ligne d'alimentation haute à ladite alimentation et,
- un deuxième signal de commande (ERASE_WL) pour, lorsque le deuxième signal de commande (ERASE_WL) est dans un premier état, commander une activation simultanée des lignes de mots, lorsque le deuxième signal de commande (ERASE_WL) est dans un deuxième état, commander une désactivation simultanée des lignes de mots.

12. Dispositif selon la revendication 11, dans lequel le bloc de commande logique (140) est doté d'un premier multiplexeur (144) et d'un deuxième multiplexeur (143), produisant respectivement le premier signal de commande (ERASE_IO) et le deuxième signal de commande (ERASE_WL), une première entrée du premier multiplexeur (144) étant reliée à une deuxième entrée du deuxième multiplexeur (143) et recevant un signal d'effacement (ERASE) dont l'état dépend du premier signal de déclenchement (SET) et du deuxième signal de déclenchement (RAND), une deuxième entrée du premier multiplexeur (144) étant reliée à une première entrée du deuxième multiplexeur (143), et recevant le signal d'effacement (ERASE) avec un retard prédéterminé, le deuxième signal de déclenchement (RAND) formant un signal de sélection commun au premier multiplexeur (144) et au deuxième multiplexeur.

13. Dispositif selon l'une des revendications 10 à 12, dans lequel un changement d'état du deuxième signal de déclenchement (RAND) est consécutif à une détection d'accès frauduleux au dispositif mémoire.

14. Dispositif selon l'une des revendications 10 à 13, dans lequel un changement d'état du premier signal de déclenchement (SET) est consécutif à une émission d'un signal provenant d'un module (120) configuré pour générer une signature numérique et/ou une clef d'encryptage et/ou un nombre aléatoire.

15. Dispositif selon l'une des revendications 1 à 14, dans lequel lors de la première phase du premier mode d'initialisation et du deuxième mode d'initialisation, la ligne d'alimentation (VirVDD) « haute » est découplée d'une alimentation au potentiel d'alimentation VDD, de sorte à ne pas alimenter le premier inverseur et le deuxième inverseur,
et dans lequel lors de la deuxième phase du premier mode et du deuxième mode d'initialisation, la ligne d'alimentation (VirVDD) « haute » est couplée à une alimentation au potentiel d'alimentation VDD, de sorte à alimenter le premier inverseur et le deuxième inverseur.

16. Utilisation d'un dispositif selon l'une des revendications 1 à 15, pour générer une signature numérique et/ou une clef d'encryptage et/ou un nombre aléatoire.

17. Procédé de commande d'un dispositif selon la revendication 9, dans lequel :
lors d'une première étape d'initialisation selon le premier mode d'initialisation, au moins une ligne de polarisation donnée parmi lesdites lignes de polarisation (691, 693) est mise à un potentiel de polarisation donné ΔV1 compris entre le potentiel de référence et le potentiel d'alimentation VDD et en particulier tel que ΔV1 < VDD/10, puis
lors d'une deuxième étape d'initialisation selon le premier mode d'initialisation, ladite ligne de polarisation donnée (691, 693) est mise à un potentiel de polarisation ΔV2 différent du potentiel de polarisation donné et compris entre le potentiel de référence et le potentiel d'alimentation VDD et en particulier tel que ΔV2 < VDD/10.
